# EUROPEAN PATENT APPLICATION

(11) **EP 2 299 506 A1**
(43) Date of publication of application: **23.03.2011**
(21) Application number: 09750692.7
(22) Date of filing: 20.05.2009
(51) Int. Cl.: H01L 51/42

(54) **ORGANIC PHOTOELECTRIC CONVERSION ELEMENT AND MANUFACTURING METHOD THEREFOR**

(30) Priority: 23.05.2008 JP 2008135288; 23.07.2008 JP 2008189502; 23.01.2009 JP 2009012867
(71) Applicant: Sumitomo Chemical Company, Limited, Tokyo 104-8260 (JP)
(72) Inventor: UETANI, Yasunori, Tsukuba-shi Ibaraki 305-0045 (JP)
(74) Representative: Vossius & Partner
(86) International application number: PCT/JP2009/059641
(87) International publication number: WO 2009/142330

(57) **Abstract**

An organic photoelectric conversion element including and anode, a cathode, an active layer disposed between the anode and the cathode, and a functional layer disposed between the active layer and the anode so as to contact the anode, wherein the functional layer is formed by a coating method using a solution having a pH of 5 to 9, and the anode is formed by a coating method.

## Description

### Technical Field

The present invention relates to an organic photoelectric conversion element and a method for manufacturing the same.

### Background Art

Recently, studies about organic photoelectric conversion elements (organic solar cells, light sensors, and the like) having an active layer formed from an organic semiconductor material have been intensively made. Particularly, when a polymer compound is used as the organic semiconductor material, since the active layer can be formed easily at low cost by a coating method which does not require a vacuum atmosphere, various studies are being made about polymer compounds having excellent solubility in organic solvents. In order to manufacture the organic photoelectric conversion element by easier steps at low cost, a studies being made on organic photoelectric conversion elements in which not only the active layer, but also an electrode and the like are formed by a coating method. For example, there is known an organic photoelectric conversion element in which an active layer is formed by application on a cathode consisting of a metal thin film and an anode is formed by application on the active layer (see, for example, Thin Solid Films, 2005, No. 491, p. 298-300). This anode is formed by applying a solution containing poly(3,4-ethylenedioxythiophene)/poly(4-styrenesulfonic acid) (PEDCT/PSS).

### Disclosure of the Invention

However, the above-described photoelectric conversion element including the active layer and the anode formed by application does not necessarily have high photoelectric conversion efficiency.

Therefore, an object of the present invention is to provide an organic photoelectric conversion element which has a high photoelectric conversion efficiency and is formed by a coating method, and a method for manufacturing the same.

The present invention provides an organic photoelectric conversion element including an anode, a cathode, an active layer disposed between the anode and the cathode, and a functional layer disposed between the active layer and the anode so as to contact the anode, wherein
the functional layer is formed by a coating method using a solution having a pH of 5 to 9, and
the anode is formed by a coating method.

The present invention also provides the organic photoelectric conversion element, wherein the anode contains polythiophene and/or a derivative of polythiophene.

The present invention also provides the organic photoelectric conversion element, wherein the coating-type anode contains polyaniline and/or a derivative of polyaniline.

The present invention also provides the organic photoelectric conversion element, wherein the active layer contains a conjugated polymer compound and a fullerene derivative.

The present invention also provides the organic photoelectric conversion element, wherein the active layer is formed by a coating method.

The present invention also provides a method for manufacturing an organic photoelectric conversion element including an anode, a cathode, an active layer disposed between the anode and the cathode, and a functional layer disposed between the active layer and the anode, the method including the steps of:
forming the functional layer by a coating method using a solution having a pH of 5 to 9 after forming the active layer, and
forming the anode on a surface of the functional layer by a coating method.

### Mode for Carrying Out the Invention

The present invention will be described in detail below.

### <Organic photoelectric conversion element>

The organic photoelectric conversion element of the present invention includes an anode, a cathode, an active layer disposed between the anode and the cathode, and a functional layer disposed between the active layer and the anode so as to contact the anode, and the functional layer is formed by a coating method using a solution having a pH of 5 to 9, and the anode is formed by a coating method.

Examples of the element constitution of the organic photoelectric conversion element include the following element constitutions:
1. An organic photoelectric conversion element including an anode; a cathode; a first active layer containing an electron-accepting compound disposed between the anode and the cathode; a second active layer containing an electron-donating compound disposed adjacently to the first active layer; and a functional layer disposed adjacently to the anode between the anode and the second active layer;
2. An organic photoelectric conversion element including an anode; a cathode; an active layer containing an electron-accepting compound and an electron-donating compound disposed between the anode and the cathode; and a functional layer disposed adjacently to the anode between the anode and the active layer; and
3. An organic photoelectric conversion element including an anode; a cathode; an active layer containing an electron-accepting compound and an electron-donating compound disposed between the anode and the cathode; and a functional layer disposed adjacently to the anode between the anode and the active layer, wherein the electron-accepting compound is a fullerene derivative.

At least one of the anode and the cathode of the organic photoelectric conversion element consists of a transparent or translucent electrode. The light energy incident from a transparent or translucent electrode is absorbed by an electron-accepting compound and/or an electron-donating compound to generate an exciton consisting of a bound electron-hole. When this exciton moves and reaches a heterojunction interface where the electron-accepting compound and the electron-donating compound are present adjacently, the electron and the hole separate due to the difference of their HOMO energy and LUMO energy in the interface to generate charges (electron and hole) capable of moving separately. The generated charges can move to respective electrodes and can be taken outside as electric energy (current).

The functional layer is preferably made of a polymer compound, and more preferably made of a highly electrically conductive polymer compound. The electrical conductivity of a highly electrically conductive polymer compound is usually from 10⁻⁵ to 10⁵ S/cm, and preferably from 10⁻³ to 10⁴ S/cm.

Examples of a material constituting the functional layer include a polymer compound having a thiophenediyl group, a polymer compound having an anilinediyl group, a polymer compound having a pyrrolediyl group, and the like. These polymer compounds may have an acid group such as a sulfonic acid group, and examples thereof include poly(thiophene) and poly (aniline) having an acid group such as a sulfonic acid group as a substituent. These poly (thiophene) and poly (aniline) may have other substituents, and examples thereof include a halogen atom, an alkyl group having 1 to 20 carbon atoms, an alkoxy group having 1 to 20 carbon atoms, an aryl group having 6 to 60 carbon atoms, and a group represented by formula (1): 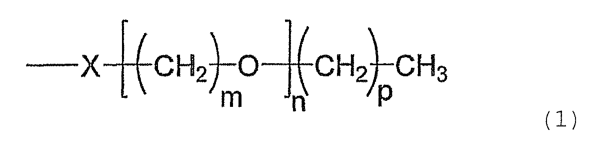 wherein n represents an integer of 1 to 4, m represents an integer of 1 to 6, p represents an integer of 0 to 5, respectively and X represents oxygen or a direct bond. From the viewpoint of solubility in water and an alcohol solvent, the polymer compound constituting the functional layer preferably has an alkoxy group or a group represented by formula (1).

The functional layer is preferably formed by a coating method using a solution having a pH of 5 to 9. The solution used in the case of forming the functional layer by the coating method contains a material constituting the functional layer and a solvent. From the viewpoint of enhancing the photoelectric conversion efficiency, the solution preferably has a pH of 6 to 8.

In the present invention, the coating solution and the solution also include a dispersion system such as an emulsion and a suspension.

By disposing the functional layer made of a highly electrically conductive polymer compound in contact with an anode between the anode and an active layer, it is possible to enhance not only tight adhesion with the anode, but also positive hole-injection efficiency from the active layer to the anode. It is preferred that the functional layer is disposed also in contact with the active layer. In such a manner, by disposing the functional layer in contact with the anode and the active layer, it is possible to enhance not only tight adhesion between the electrode and the active layer, but also positive hole-injection efficiency from the active layer to the anode. By disposing such a functional layer, it is possible to realize an organic photoelectric conversion element which has high reliability and a high photoelectric conversion efficiency. In the present description, the polymer compound means a compound having a polystyrene-equivalent number average molecular weight of 500 or more.

In the present description, the pH is a value measured using a pH test paper.

The functional layer functions as a so-called positive hole transport layer and/or a positive hole injection layer. The functions of the functional layer include a function to enhance an injection efficiency of a positive hole into an anode, a function to prevent injection of an electron from an active layer, a function to enhance a transport ability of a positive hole, a function to protect an active layer from erosion with a solution used in the case of forming an anode by a coating method, a function to suppress deterioration of an active layer, and the like.

The functional layer is preferably constituted with a material having high wettability with a solution used in the case of forming an anode by application. Specifically, it is preferred that wettability of the functional layer with the solution used in the case of forming an anode by application is higher than wettability of the active layer with the solution used in the case of forming an anode by application. Since the anode is formed on the functional layer by application, satisfactory wetting and spreading of the solution over the surface of the functional layer occur in the case of forming the anode, and thus an anode having a uniform film thickness can be formed. The wettability can be evaluated by measuring a contact angle. The contact angle is usually 90° or less, and preferably 45° or less.

The anode is preferably formed by a coating method. The solution used in the case of forming the anode by the coating method contains a material constituting the anode, and a solvent. The anode preferably contains a polymer compound which exhibits electrical conductivity, and preferably essentially consists of a polymer compound which exhibits electrical conductivity. Examples of the material constituting the anode include organic materials such as polyaniline and derivatives thereof, polythiophene and derivatives thereof, and polypyrrole and derivatives thereof. It is preferred that the anode is constituted with polythiophene and/or derivatives of polythiophene, and essentially consists of polythiophene and/or derivatives of polythiophene. It is preferred that the anode is constituted with polyaniline and/or derivatives of polyaniline, and consists of polyaniline and/or derivatives of polyaniline.

Specific examples of polythiophene and derivatives thereof include compounds containing, as repeating unit (s), one or more among the following plural structural formulas: 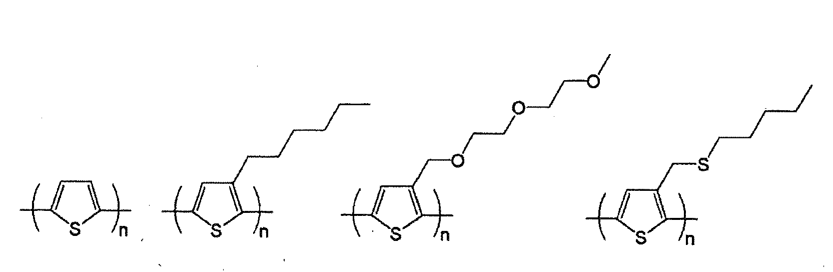 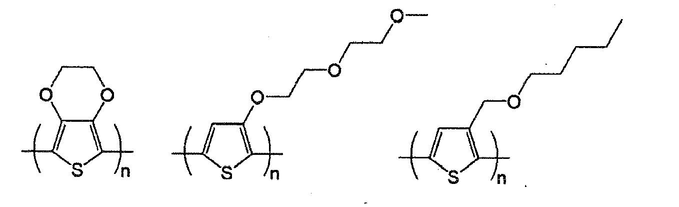 wherein n represents an integer of 2 or more.

Specific examples of polypyrrole and derivatives thereof include compounds containing, as repeating unit (s), one or more of the following plural structural formulas: 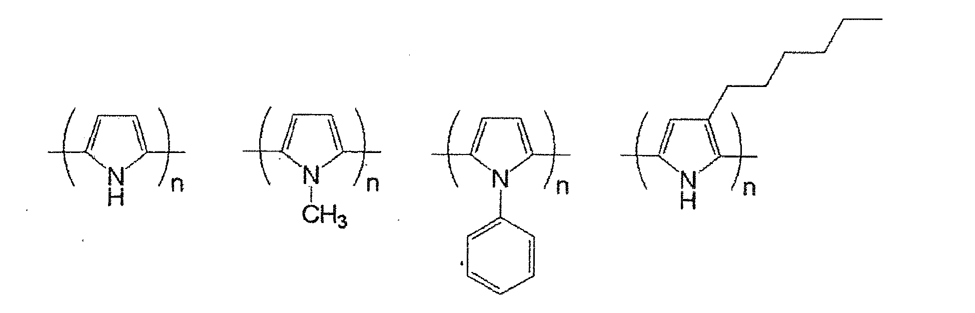 wherein n represents an integer of 2 or more.

Specific examples of polyaniline and derivatives thereof include compounds containing, as repeating unit (s), one or more among the following plural structural formulas: 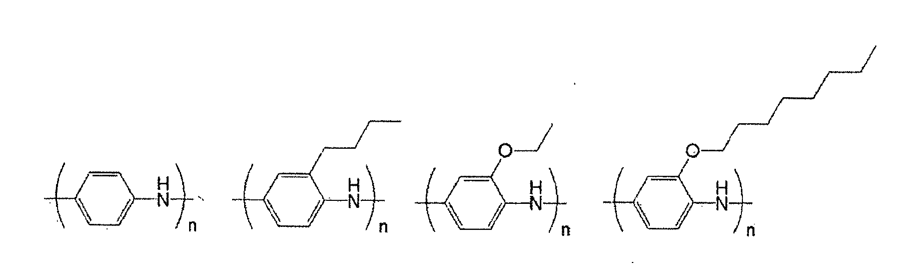 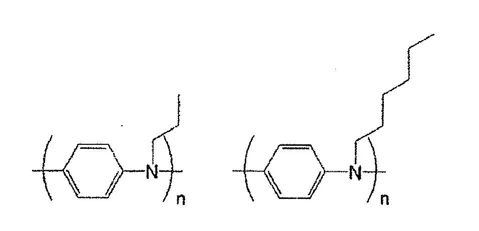 wherein n represents an integer of 2 or more.

Among the above-described materials constituting the anode, PEDOT/PSS made of poly(3,4-ethylenedioxythiophene) (PEDOT) and poly (4-styrenesulfonic acid) (PSS) is suitably used as the material constituting the anode from the viewpoint of a high photoelectric conversion efficiency. PEDOT/PSS is usually sold as an aqueous dispersion liquid. In order to enhance coatability on the organic film, the aqueous dispersion liquid may be modified by adding alcohol solvents such as ethanol and isopropanol, surfactants, and the like. It is also possible to enhance electrical conductivity by adding ethylene glycol, N-methylpyrrolidone, dimethyl sulfoxide, and the like to the aqueous dispersion liquid.

The anode may be formed by a coating method using a metal ink, a metal paste, a low-melting metal in a molten state, or the like without limitation to the solution containing the above-described organic material.

The active layer in the organic photoelectric conversion element of the present invention is preferably formed by a coating method. The active layer preferably contains a polymer compound, and may contain a single polymer compound, or two or more polymer compounds in combination. It is also possible to use a mixture of an electron-donating compound and/or an electron-accepting compound in the active layer in order to enhance a charge transport ability of the active layer. In particular, it is preferable that a conjugated polymer compound and a fullerene derivative are contained in the active layer. For example, it is possible to use an organic thin film containing a conjugated polymer compound and a fullerene derivative as an active layer.

The above-described organic thin film usually has a film thickness within a range from 1 nm to 100 µm, preferably from 2 nm to 1, 000 nm, more preferably from 5 nm to 500 nm, and still more preferably from 20 nm to 200 nm.

In the organic photoelectric conversion element of the above-described item 3 mentioned as an example of a specific element constitution of the organic photoelectric conversion element, the proportion of the fullerene derivative in the active layer containing the fullerene derivative and an electron-donating compound is preferably from 10 to 1, 000 parts by weight, and more preferably from 50 to 500 parts by weight, based on 100 parts by weight of the electron-donating compound. The organic photoelectric conversion element preferably has an element constitution of the above-described item 2 or 3, and more preferably has an element constitution of the above-described item 3 from the viewpoint that it contains many heterojunction interfaces.

The electron-accepting compound used for the organic photoelectric conversion element consists of a compound in which the HOMO energy of the electron-accepting compound is higher than the HOMO energy of an electron-donating compound, and the LUMO energy of the electron-accepting compound is higher than the LUMO energy of the electron-donating compound.

The electron-donating compound may be a low-molecular compound or a polymer compound. Examples of the low-molecular compound include phthalocyanine, metallophthalocyanine, porphyrin, metalloporphyrin, oligothiophene, tetracene, pentacene, rubrene, and the like. Examples of the polymer compound include polyvinyl carbazole and derivatives thereof, polysilane and derivatives thereof, polysiloxane derivatives having an aromatic amine in a side chain or a main chain, polyaniline and derivatives thereof, polythiophene and derivatives thereof, polypyrrole and derivatives thereof, polyphenylene vinylene and derivatives thereof, polythienylene vinylene and derivatives thereof, polyfluorene and derivatives thereof, and the like.

The electron-accepting compound may be a low-molecular compound or a polymer compound. Examples of the low-molecular compound include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, fullerenes such as C₆₀ fullerene and derivatives thereof, phenanthrene derivatives such as bathocuproine, and the like. Examples of the polymer compound include polyvinyl carbazole and derivatives thereof, polysilane and derivatives thereof, polysiloxane derivatives having an aromatic amine in a side chain or a main chain, polyaniline and derivatives thereof, polythiophene and derivatives thereof, polypyrrole and derivatives thereof, polyphenylene vinylene and derivatives thereof, polythienylene vinylene and derivatives thereof, polyfluorene and derivatives thereof, and the like.

Among them, fullerenes and derivatives thereof are preferred.

The fullerenes include C₆₀ fullerene, C₇₀ fullerene, carbon nanotube fullerene, and the like. The following compounds are mentioned as examples of C₆₀ fullerene derivatives.

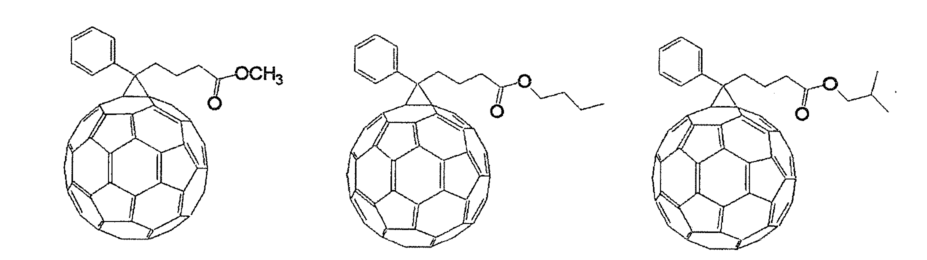

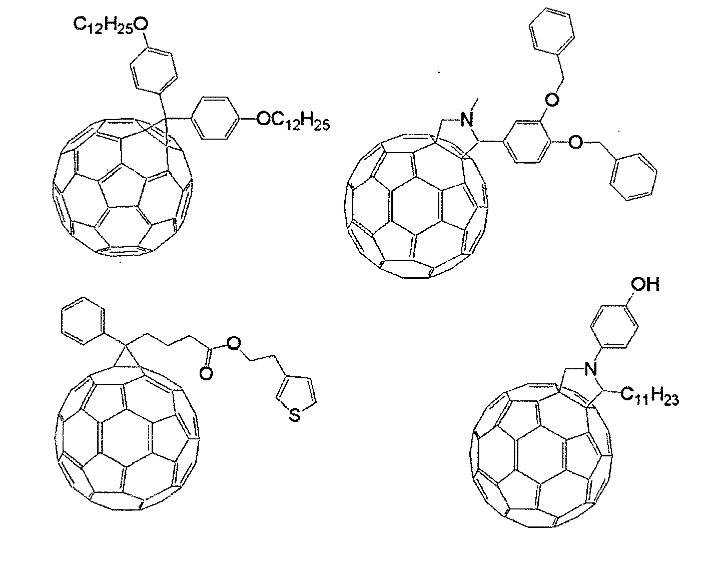

Examples of the conjugated polymer compound include polymer compounds which contain, as a repeating unit, one group or two or more groups selected from the group consisting of an unsubstituted or substituted fluorenediyl group, an unsubstituted or substituted benzofluorenediyl group, a dibenzofurandiyl group, an unsubstituted or substituted dibenzothiophenediyl group, an unsubstituted or substituted carbazolediyl group, an unsubstituted or substituted thiophenediyl group, an unsubstituted or substituted furandiyl group, an unsubstituted or substituted pyrrolediyl group, an unsubstituted or substituted benzothiadiazolediyl group, an unsubstituted or substituted phenylenevinylenediyl group, an unsubstituted or substituted thienylenevinylenediyl group, and an unsubstituted or substituted triphenylaminediyl group, the repeating unit being bound to another repeating unit directly or via a linking group.

When the repeating unit is bound to another repeating unit via a linking group in the conjugated polymer compound, examples of the linking group include phenylene, biphenylene, naphthalenediyl, anthracenediyl, and the like.

Preferable examples of the conjugated polymer compound include polymer compounds which contain one repeating unit or two or more repeating units selected from the group consisting of polymer compounds having a fluorenediyl group and a thiophenediyl group, the repeating unit being bound to another repeating unit directly or via a linking group.

The organic photoelectric conversion element of the present invention is usually formed on a substrate. The substrate may be any material which does not alter when the organic photoelectric conversion element is manufactured. Examples of the material for the substrate include glass, plastic, polymer films, silicon, and the like. When the organic photoelectric conversion element is formed on an opaque substrate, an electrode opposite to the electrode provided at the substrate side (i.e. an electrode distal from the substrate) is preferably transparent or translucent. By using such an electrode, it is possible to capture light from the electrode opposite the electrode provided at the substrate side.

An electrically conductive metal oxides film, a translucent metal thin film, a transparent conductive film containing an organic substance, and the like are used as a transparent or translucent electrode. Specifically, thin films made of indium oxide, zinc oxide, tin oxide, indium tin oxide (abbreviation: ITO), indium zinc oxide (abbreviation: IZO), gold, platinum, silver, copper, aluminum, polyaniline or a derivative thereof, polythiophene or a derivative thereof, or the like may be used as the electrode. Among them, a thin film of ITO, IZO, or tin oxide is preferably used.

The element constitution of the organic photoelectric conversion element is not limited to the above-described element constitution, and an additional layer may be further provided between an anode and a cathode. Examples of the additional layer include a positive hole transport layer which transports a hole, an electron transport layer which transports an electron, a buffer layer, and the like. For example, the positive hole transport layer is provided between a functional layer and an active layer, the electron transport layer is provided between an active layer and a cathode, and the buffer layer is provided between a cathode and an electron transport layer. It is possible to promote flattening of the surface and injection of charges by providing the buffer layer.

It is possible to use, as the material used for the hole transport layer and the electron transport layer as the additional layer, the above-described electron-donating compound and electron-accepting compound, respectively. It is possible to use, as the material used for the buffer layer as the additional layer, a halide or an oxide of an alkali metal or an alkaline earth metal such as lithium fluoride, or the like. It is also possible to form a charge transport layer using fine particles of an inorganic semiconductor such as titanium oxide. For example, the electron transport layer can be formed by applying a titania solution on an under layer, on which the electron transport layer is to be formed, using a coating method, followed by drying.

### <Method for manufacturing organic photoelectric conversion element>

The method for manufacturing an organic photoelectric conversion element of the present invention is a method for manufacturing an organic photoelectric conversion element including an anode, a cathode, an active layer disposed between the anode and the cathode, and a functional layer disposed between the active layer and the anode, the method including the steps of forming the functional layer by a coating method using a solution having a pH of 5 to 9 after forming the active layer, and forming the anode on the surface of the functional layer by a coating method.

### (Cathode forming step)

The cathode is formed by forming a film of the above-described transparent or translucent electrode material on the above-described substrate using a vacuum vapor deposition method, a sputtering method, an ion plating method, a plating method, or the like. Alternatively, the cathode can be formed by a coating method using a solution containing an organic material such as polyaniline and derivatives thereof or polythiophene and derivatives thereof, a metal ink, a metal paste, a low-melting metal in a molten state, or the like.

### (Active layer forming step)

The organic thin film used as the active layer can be formed, for example, by a coating method using a solution containing the above-described material constituting the active layer and a solvent and can be formed. Namely, it can be formed, for example, by a coating method using a solution containing a conjugated polymer compound and a fullerene derivative, and a solvent.

Examples of the solvent include hydrocarbon solvents such as toluene, xylene, mesitylene, tetralin, decalin, bicyclohexyl, n-butylbenzene, s-butylbenzene, and t-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, and bromocyclohexane; halogenated unsaturated hydrocarbon solvents such as chlorobenzene, dichlorobenzene, and trichlorobenzene; ether solvents such as tetrahydrofuran and tetrahydropyran; and the like.

The solution used in the present invention may contain two or more solvents, and may also contain two or more solvents described above.

Examples of the method of applying the solution containing the material constituting the active layer include coating methods such as a spin coating method, a casting method, a microgravure coating method, a gravure coating method, a bar coating method, a roll coating method, a wire bar coating method, a dip coating method, a spray coating method, a screen printing method, a flexographic printing method, an offset printing method, an ink jet printing method, a dispenser printing method, a nozzle coating method, and a capillary coating method. Among these coating methods, a spin coating method, a flexographic printing method, an ink jet printing method, and a dispenser printing method are preferred.

### (Functional layer forming step)

The functional layer is formed by a coating method using a solution having a pH of 5 to 9 after formation of the active layer. This solution contains a material constituting the functional layer, and a solvent. When the functional layer is provided in contact with the active layer, the functional layer is formed by applying the solution having a pH of 5 to 9 to the surface of the active layer. It is preferred to form the functional layer using a solution which causes less damage to the layer (active layer, or the like) to which the solution is to be applied. Specifically, it is preferred to form the functional layer using a solution which hardly dissolve the layer (active layer, or the like) to which the solution is to be applied. For example, if the solution used in the case of forming an anode is applied to the active layer, it is preferred to form the functional layer using a solution which causes less damage to the active layer than the solution applied to the active layer. Specifically, it is preferred to form the functional layer using a solution which more hardly dissolves the active layer than the solution used in the case of forming an anode.

The solution used in the case of forming the functional layer by application contains a solvent, and the above-described material constituting the functional layer. Examples of the solvent of the solution include water, alcohols, and the like, and specific examples of the alcohols include methanol, ethanol, isopropanol, butanol, ethylene glycol, propylene glycol, butoxyethanol, methoxybutanol, and the like. The solution used in the present invention may contain two or more solvents, and may also contain two or more solvents described above.

### (Anode forming step)

The anode is formed on the surface of the functional layer by a coating method. Specifically, the anode is formed by applying a solution containing a solvent and the above-described material constituting the anode to the surface of the functional layer. Examples of the solvent of the solution used in the case of forming the anode include hydrocarbon solvents such as toluene, xylene, mesitylene, tetralin, decalin, bicyclohexyl, n-butylbenzene, s-butylbenzene, and t-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, and bromocyclohexane; halogenated unsaturated hydrocarbon solvents such as chlorobenzene, dichlorobenzene, and trichlorobenzene; ether solvents such as tetrahydrofuran and tetrahydropyran; water; alcohols; and the like. Specific examples of alcohols include methanol, ethanol, isopropanol, butanol, ethylene glycol, propylene glycol, butoxyethanol, methoxybutanol, and the like. The solution used in the present invention may contain two or more solvents, and may also contain two or more solvents described above.

The organic photoelectric conversion element of the present invention can generate photovoltaic power between electrodes by irradiating with light such as solar light through transparent or translucent electrodes, and can operate as an organic thin film solar cell.

By accumulating a plurality of organic thin film solar cells, the cells can be used as an organic thin film solar cell module.

Photocurrent can flow by irradiating with light through transparent or translucent electrodes while applying voltage between the electrodes, and the organic photoelectric conversion element of the present invention can operate as an organic light sensor. By accumulating a plurality of organic light sensors, the sensors can be used as an organic image sensor.

### Examples

In the following, the present invention will be described in more detail by way or examples, but the present invention is not limited thereto.

In the following examples, the polystyrene-equivalent number average molecular weight of the polymer was determined by using GPC (PL-GPC2000) manufactured by GPC Laboratory. Polymers were dissolved in o-dichlorobenzene so as to give solutions each having a concentration of about 1% by weight, which were used as measurement samples. As a mobile phase of the GPC, o-dichlorobenzene was used. The above-described measurement samples were run at a flow rate of 1 mL/min at a measurement temperature of 140°C. As a column, three PLGEL 10 µm MIXED-B columns (manufactured by PL Laboratory) connected in series were used.

### Synthesis Example 1

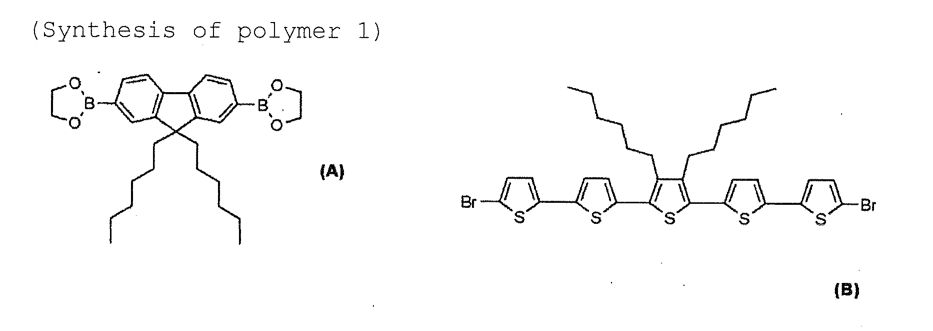

The compound of the above-described formula (A) (7.928 g, 16.72 mmol), the compound of the above-described formula (B) (13.00 g, 17.60 mmol), methyltrioctylammonium chloride (trade name: aliquat 336, manufactured by Aldrich, CH₃N [(CH₂)₇CH₃]₃Cl, density 0.884 g/ml, 25°C, trademark of Henkel Corporation) (4.979 g), and toluene (405 ml) were charge into an argon-substituted 2 L four-necked flask, and the inside of the flask was degassed by argon-bubbling for 30 minutes with stirring. Dichlorobis(triphenylphosphine)palladium (II) (0.02 g) was added to the flask, the mixture was heated to 105°C, and 2 mol/L of an aqueous sodium carbonate solution (42.2 ml) was added dropwise to the flask with stirring. After completion of the dropwise addition, the mixture was reacted for 5 hours, phenylboronic acid (2.6 g) and toluene (1. 8 ml) were then added to the flask, and the mixture was stirred at 105°C for 16 hours. Toluene (700 ml) and a 7.5% aqueous solution of sodium diethyldithiocarbamate trihydrate (200 ml) were added to the flask, and the mixture was stirred at 85°C for 3 hours. After removing the aqueous layer from the reaction mixture, the reaction mixture was washed twice with 300 ml of ion-exchange water of 60°C, washed once with 300 ml of 3% acetic acid of 60°C, and then washed thrice with 300 ml of ion-exchange water of 60°C. The organic layer was passed through a column filled with Celite, alumina and silica, and the column was washed with hot toluene (800 ml). The resulting solution was concentrated to a volume of 700 ml and poured into 2 L of methanol to obtain a polymer by reprecipitation. The obtained polymer was recovered by filtration, washed in turn with 500 ml of methanol, acetone and methanol, and then vacuum-dried overnight at 50°C to obtain 12.21 g of a pentathienyl-fluorene copolymer (hereinafter referred to as a "polymer 1") having the repeating unit represented by the following formula:

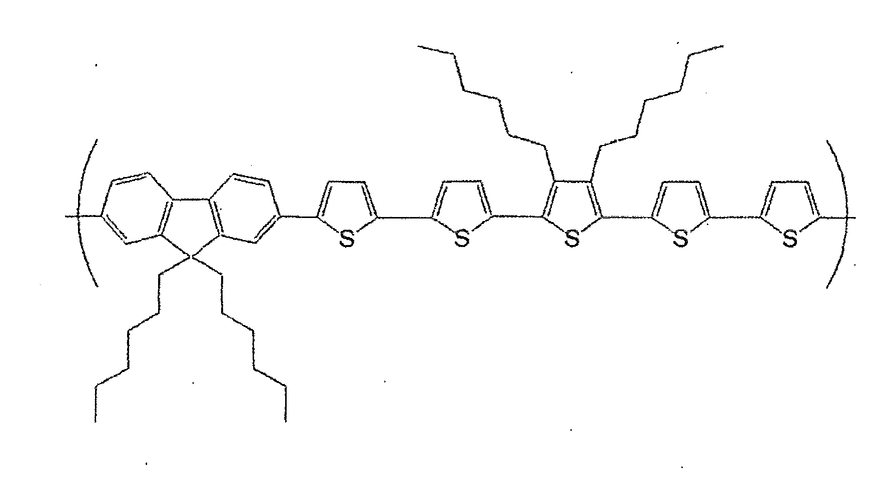

The polystyrene-equivalent number average molecular weight of the polymer 1 was 5.4 × 10⁴ and the weight average molecular weight was 1.1 × 10⁵.

### (Preparation of composition 1)

[6,6]-Phenyl C61-methyl butylate ester (PCBM) (15 parts by weight) (manufactured by Frontier Carbon, E100) as a fullerene derivative, 5 parts by weight of the polymer 1 as an electron-donating compound, and 1,000 parts by weight of o-dichlorobenzene as a solvent were mixed. Then, the mixed solution was filtrated through a Teflon® filter having a pore size of 1.0 µm to prepare a composition 1.

### (Preparation of modified PEDOT/PSS)

Highly electrically conductive PEDOT/PSS (trade name: CLEVIOS PH500, manufactured by H.C. Starck Inc.), ethylene glycol, isopropanol and a surfactant (Surfinol 104PA, manufactured by Air Products and Chemicals, Inc., active ingredient: 50%) were mixed at a weight ratio of 80/20/200/1 to prepare modified PEDOT/PSS. The pH of the modified PEDOT/PSS solution was measured by a pH test paper (manufactured by Advantec Toyo, trade name "UNIVERSAL", model number "07011030") . As a result, the pH was 2.

### Example 1

### (Preparation and evaluation of organic thin film solar cell)

To a glass substrate having a 150 nm-thick ITO film formed by a sputtering method, which serves as an anode (anode as a solar cell), a solution prepared by diluting a nano-titania solution (PASOL HDW-10R #BF18) manufactured by Catalysts and Chemicals Industries Co., Ltd. with isopropanol (2-told weight) was applied by spin coating. After drying in atmospheric air under the condition of 120°C for 10 minutes, an electron transport layer was obtained. The obtained electron transport layer had a film thickness of about 20 nm. Then, the composition 1 was applied by spin coating to obtain an active layer (film thickness: about 100 nm) of an organic thin film solar cell. Then, an HIL691 solution (manufactured by Plextronics, trade name Plexcore HIL691) was applied by spin coating to obtain a functional layer (film thickness: about 100 nm). The pH of the HIL691 solution was 7 upon measuring using a pH test paper (manufactured by Advantec Toyo, trade name "Universal", model number "07011030"). Then, modified PEDOT/PSS was applied by spin coating and dried in vacuum for 60 minutes to obtain an anode (anode as a solar cell). The film thickness of the modified PEDOT/PSS after drying was about 100 nm. The shape of the obtained organic thin film solar cell was a square measuring 2 mm × 2 mm. The photoelectric conversion efficiency of the obtained organic thin film solar cell was determined by irradiating with constant light using Solar Simulator (manufactured by Bunkoukeiki Co., Ltd., trade name OTENTO-SUNII: AM1.5G filter, irradiance: 100 mW/cm²), and measuring the current and voltage generated. The photoelectric conversion efficiency was 1.2%.

### Example 2

### (Preparation and evaluation of organic thin film solar cell)

To a glass substrate having a 100 nm-thick aluminum film formed by a vacuum vapor deposition machine, which serves as a cathode, a solution prepared by diluting a nano-titania solution (PASOL HDW-10R #BF18) manufactured by Catalysts and Chemicals Industries Co. , Ltd. with isopropanol (2-fold weight) was applied by spin coating. After drying in atmospheric air under the condition of 120°C for 10 minutes, an electron transport layer was obtained. The obtained electron transport layer had a film thickness of about 20 nm. Then, the composition 1 was applied to the substrate by spin coating to obtain an active layer (film thickness: about 100 nm) of an organic thin film solar cell. Then, an HIL691 solution (manufactured by Plextronics, trade name Plexcore HIL691) was applied by spin coating to obtain a functional layer (film thickness: about 100 nm). Then, modified PEDOT/PSS was applied by spin coating and dried in vacuum for 60 minutes. The film thickness of the modified PEDOT/PSS after drying was about 100 nm. The shape of the obtained organic thin film solar cell was a square measuring 2 mm × 2 mm. The photoelectric conversion efficiency of the obtained organic thin film solar cell was determined by irradiating with constant light using Solar Simulator (manufactured by Bunkoukeiki Co., Ltd., trade name OTENTO-SUNII: AM1.5G filter, irradiance: 100 mW/cm²), and measuring the current and voltage generated. The photoelectric conversion efficiency was 1.0%.

### Example 3

### (Preparation and evaluation of organic thin film solar cell)

To a glass substrate having a 150 nm-thick ITO film formed by a sputtering method, which serves as a cathode, a solution prepared by diluting a nano-titania solution (PASOL HDW-10R #BF18) manufactured by Catalysts and Chemicals Industries Co. , Ltd. with isopropanol (2-fold weight) was applied by spin coating. After drying in atmospheric air under the condition of 120°C for 10 minutes, an electron transport layer was obtained. The obtained electron transport layer had a film thickness of about 20 nm. Then, the composition 1 was applied by spin coating to obtain an active layer (film thickness: about 100 nm) of an organic thin film solar cell. Then, an HIL691 solution (manufactured by Plextronics, trade name Plexcore HIL691) was applied by spin coating to obtain a functional layer (film thickness: about 100 nm). Then, a polyaniline solution (manufactured by Nissan Chemical Industries, Ltd., ORMECON D1033W (aqueous solvent)) was applied and dried in vacuum for 60 minutes. The film thickness of polyaniline was about 130 nm. The shape of the obtained organic thin film solar cell was a square measuring 2 mm × 2 mm.

The photoelectric conversion efficiency of the obtained organic thin film solar cell was determined by irradiating with constant light using Solar Simulator (manufactured by Bunkoukeiki Co. , Ltd., trade name OTENTO-SUNI I: AM1. 5G filter, irradiance: 100 mW/cm²) , and measuring the current and voltage generated. The photoelectric conversion efficiency was 2.4%.

### Example 4

### (Preparation and evaluation of organic thin film solar cell)

To a glass substrate having a 150 nm-thick ITO film formed by a sputtering method, which serves as a cathode, a solution prepared by diluting a nano-titania solution (PASOL HDW-10R #BF18) manufactured by Catalysts and Chemicals Industries Co., Ltd. with isopropanol (2-fold weight) was applied by spin coating. After drying in atmospheric air under the condition of 120°C for 10 minutes, an electron transport layer was obtained. The obtained electron transport layer had a film thickness of about 20 nm. Then, the composition 1 was applied by spin coating to obtain an active layer (film thickness: about 100 nm) of an organic thin film solar cell. Then, an HIL691 solution (manufactured by Plextronics, trade name Plexcore HIL691) was applied by spin coating to obtain a functional layer (film thickness: about 100 nm). Then, a polyaniline solution (manufactured by Nissan Chemical Industries, Ltd., ORMECON NX-D103X (xylene solvent)) was applied and dried in vacuum for 60 minutes. The film thickness of polyaniline was about 230 nm. The shape of the obtained organic thin film solar cell was a square measuring 2 mm × 2 mm. The photoelectric conversion efficiency of the obtained organic thin film solar cell was determined by irradiating with constant light using Solar Simulator (manufactured by Bunkoukeiki Co., Ltd., trade name OTENTO-SUNII: AM1.5G filter, irradiance: 100 mW/cm²), and measuring the current and voltage generated. The photoelectric conversion efficiency was 1.9%.

### Example 5

### (Preparation and evaluation of organic thin film solar cell)

To a glass substrate having a 150 nm-thick ITO film formed by a sputtering method, which serves as a cathode, a solution prepared by diluting a nano-titania solution (PASOL HDW-10R #BF18) manufactured by Catalysts and Chemicals Industries Co., Ltd. with isopropanol (2-fold weight) was applied by spin coating. After drying in atmospheric air under the condition of 120°C for 10 minutes, an electron transport layer was obtained. The obtained electron transport layer had a film thickness of about 20 nm. Then, the composition 1 was applied by spin coating to obtain an active layer (film thickness: about 100 nm) of an organic thin film solar cell. Then, an OC1200 solution (manufactured by Plextronics, trade name: Plexcore OC1200, purchased from Sigma-Aldrich Corporation) was applied by spin coating to obtain a hole transport layer (film thickness: about 50 nm), which serves as a functional layer. The pH of the OC1200 solution was 7 upon measuring using a pH test paper (manufactured by Advantec Toyo, trade name "Universal", model number "07011030"). Then, a polyaniline solution (manufactured by Nissan Chemical Industries, Ltd., ORMECON NX-D103X (xylene solvent)) was applied and dried in vacuum for 60 minutes.

The film thickness of polyaniline was about 130 nm. The shape of the obtained organic thin film solar cell was a square measuring 2 mm × 2 mm. The photoelectric conversion efficiency of the obtained organic thin film solar cell was determined by irradiating with constant light using Solar Simulator (manufactured by Bunkoukeiki Co., Ltd., trade name OTENTO-SUNII: AM1.5G filter, irradiance: 100 mW/cm²), and measuring the current and voltage generated.

The photoelectric conversion efficiency was 2.8%.

Plexcore OC1200 is a solution of 2% ethylene glycol monobutyl ether of sulfonated polythiophene shown below and water (3 : 2).

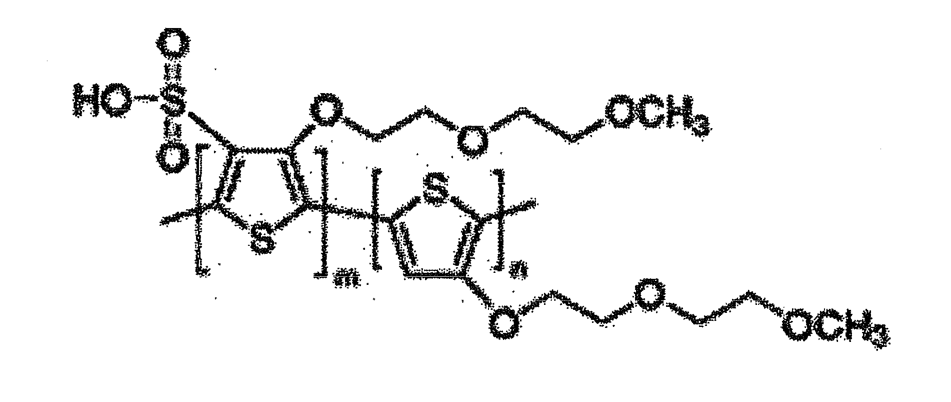

### Comparative Example 1

### (Preparation and evaluation of organic thin film solar cell)

To a glass substrate having a 150 nm-thick ITO film formed by a sputtering method, which serves as a cathode, a solution prepared by diluting a nano-titania solution (PASOL HDW-10R #BF18) manufactured by Catalysts and Chemicals Industries Co., Ltd. with isopropanol (2-fold weight) was applied by spin coating. After drying in atmospheric air under the condition of 120°C for 10 minutes, an electron transport layer was obtained. The obtained electron transport layer had a film thickness of about 20 nm. Then, the composition 1 was applied by spin coating to obtain an active layer (film thickness: about 100 nm) of an organic thin film solar cell. Then, modified PEDOT/PSS was applied and dried in vacuum for 60 minutes. After drying, the film thickness of the modified PEDOT/PSS was about 100 nm. The shape of the obtained organic thin film solar cell was a square measuring 2 mm x 2 mm. The photoelectric conversion efficiency of the obtained organic thin film solar cell was determined by irradiating with constant light using Solar Simulator (manufactured by Bunkoukeiki Co., Ltd., trade name OTENTO-SUNII: AM1.5G filter, irradiance: 100 mW/cm²), and measuring the current and voltage generated. The photoelectric conversion efficiency was 0.5%.

### -Evaluation-

As is apparent from the above, in an organic photoelectric conversion element in which an anode is formed by a coating method, when a functional layer is formed by using an HIL691 solution or an OC1200 solution of pH 7, electricity was generated with higher photoelectric conversion efficiency than that in the case of an organic photoelectric conversion element having no functional layer.

### Industrial Applicability

The organic photoelectric conversion element of the present invention exhibits a high photoelectric conversion efficiency and is also capable of forming an active layer, a functional layer and an anode by application, and therefore can be manufactured by easy steps at low cost.

## Claims

1. An organic photoelectric conversion element comprising an anode, a cathode, an active layer disposed between the anode and the cathode, and a functional layer disposed between the active layer and the anode so as to contact the anode, wherein
the functional layer is formed by a coating method using a solution having a pH of 5 to 9, and
the anode is formed by a coating method.

2. The organic photoelectric conversion element according to claim 1, wherein the anode contains polythiophene and/or a derivative of polythiophene.

3. The organic photoelectric conversion element according to claim 1, wherein the anode contains polyaniline and/or a derivative of polyaniline.

4. The organic photoelectric conversion element according to any one of claims 1 to 3, wherein the active layer contains a conjugated polymer compound and a fullerene derivative.

5. The organic photoelectric conversion element according to any one of claims 1 to 4, wherein the active layer is formed by a coating method.

6. A method for manufacturing an organic photoelectric conversion element comprising an anode, a cathode, an active layer disposed between the anode and the cathode, and a functional layer disposed between the active layer and the anode, the method comprising the steps of:
forming the active layer,
forming the functional layer by a coating method using a solution having a pH of 5 to 9 after forming the active layer, and
forming the anode on a surface of the functional layer by a coating method.
